# EUROPEAN PATENT SPECIFICATION

(11) **EP 4 203 634 B1**
(45) Date of publication and mention of the grant of the patent: **20.08.2025**
(21) Application number: 22215100.3
(22) Date of filing: 20.12.2022
(51) Int. Cl.: H05K 7/14

(54) **A FIXING UNIT, A MOVEABLE ASSEMBLY, A BASE UNIT AND A METHOD FOR RELEASING A MOVEABLE ASSEMBLY**
BEFESTIGUNGSEINHEIT, BEWEGLICHE ANORDNUNG, BASISEINHEIT UND VERFAHREN ZUM LÖSEN EINER BEWEGLICHEN ANORDNUNG
UNITÉ DE FIXATION, ENSEMBLE MOBILE, UNITÉ DE BASE ET PROCÉDÉ DE LIBÉRATION D'UN ENSEMBLE MOBILE

(30) Priority: 21.12.2021 EP 21216599
(43) Date of publication of application: 28.06.2023
(73) Proprietor: Reichle & De-Massari AG, 8620 Wetzikon (CH)
(72) Inventor: Zhelyazkov, Evgeni, 1000 Sofia (BG); Alvarez, Bryce, Milpitas California, 95035 (US)
(74) Representative: Daub, Thomas

(56) References cited:
- US-A1- 2021 037 667

## Description

### State of the art

The invention relates to a fixing unit according to claim 1, a base unit according to claim 12 and a method for releasing a moveable assembly according to claim 13.

From the state of the art drawer units, in particular panels, are known, which are movable for an insertion into a cabinet. Moreover, snap-in connections or locking connections are also known to fix the drawer unit in cabinet. Such a drawer unit is known e.g. from the document US 2021/037667 A1.

The objective of the invention is, in particular, to provide a fixing unit with improved characteristics regarding flexibility, construction and/or a fixation. The objective is achieved, according to the invention, by the features of claims 1, 12 and 13, while advantageous implementations and further developments of the invention may be gathered from the dependent claims.

### Advantages of the invention

The invention is based on a fixing unit for fixing a movable unit in at least one guiding rail. It is proposed that the fixing unit is movable parallel to a move direction of the movable unit into a release position in order to release the movable unit from the guiding rail.

By means of the invention an enhanced flexibility, construction and/or a fixation can be achieved. In particular a flexible mechanism for fixing a movable unit can be achieved. Moreover, a compact embodiment can be achieved. This allows achieving a particularly flexible drawer system, in particular a cable management, without affecting other movable units and/or further movable units during movement of one movable unit and/or fixing the movable unit. Furthermore, a handling can be simplified as the fixing unit is intended for reversibly fixing the movable unit in at least one guiding rail. In addition, a comfort, in particular a user comfort, can be increased. Additionally, in turn of a fixing unit which is movable parallel to a move direction of the movable unit, a simple and efficient fixation and/or releasing can be provided. Due to the fixing unit which is movable parallel to the move direction, preferably at least two mechanism options for releasing the movable unit can be provided for the user, in particular pushing and pulling the fixing unit.

At least the fixing unit can be part of a moveable assembly. Further, the moveable assembly can comprise the movable unit, in particular which is embodied as a drawer unit. A drawer system is to be understood, in this context, as a modular construction system, which comprises a certain number of elements and units to provide a system with at least the moveable assembly. In particular, the drawer system comprises a base unit. Preferably, the base unit comprises at least the moveable assembly. In particular, the moveable unit is movable relative to the base unit and can be inserted and pulled out of the base unit. Particularly preferably, the movable unit is embodied as a drawer unit. For example, the drawer system can be part of a household system. The household system can comprise at least one item of household furniture and/or household appliance. "Household system" is to be understood in this connection as a system for use in a household environment and/or for use with household objects, which in particular comprises at least one, in particular at least one partially electronic, item of household furniture, such as for example a food store and/or a spice rack, a cutlery cabinet and/or a tableware cabinet, and/or at least one household appliance, for example a household refrigeration appliance and/or a wine cooler and/or a cooking appliance and/or a washing appliance, like a washing machine and/or a dishwasher. The base unit can be at least one of this said items of household furniture and/or household appliance or at least a part of it. Further, the drawer system, in particular at least base unit and/or the movable assembly, can be used for example in a pharmacy and/or in a workshop and/or in a doctor's office and/or in a medical practice and/or in a hospital. In particular, the drawer system, in particular the movable assembly, can be used wherever a drawer system, in particular a movable assembly, is needed.

In a preferred embodiment of this invention the drawer system is a cable management system. A "cable management system" is to be understood, in this context, as a modular construction system, which comprises a certain number of elements to build preferably in a modular way a unit or device which is configured to execute at least one function in at least one operational state. The cable management system is a system, preferably for use in a fiber optic network, in particular a data center. In particular, the cable management system is configured for terminating at least one cable and preferably a plurality of cables, in particular patch cables and/or for supporting an interconnection between a plurality of cables, in particular patch cables. Herein, the cable management system is preferably embodied as an optical distribution frame. Moreover, the cable management system may also comprise at least one cable, preferably optical waveguide cable. The drawer system can comprise at least one carrier unit, which may preferably be embodied as a rack and which is in particular configured for fastening the base unit at least indirectly and/or directly. Preferably, the base unit is embodied as a cable management unit. A "cable management unit" is to be understood, in this context, as a unit which is, in at least one operational state, configured for managing, in particular guiding, connecting, coupling, terminating and/or distributing, cables, in particular patch cables, in particular the plurality of cables, in particular the plurality of patch cables, preferably optical waveguide cables.

In particular, the base unit comprises at least one frame unit, in particular a chassis and/or an exterior housing, which can preferably be fastened to the carrier unit of the drawer system, in particular the cable management system, and which is configured to at least partly and preferably at least largely delimit at least one receiving space for receiving at least the moveable assembly and/or at least one further moveable assembly and preferably a plurality of moveable assemblies and/or further moveable assemblies, in particular at least two, preferably at least three and most preferably at least six moveable assemblies and/or further moveable assemblies. Preferably, the frame unit is an optical distribution frame unit.

Moreover, the base unit, in particular the cable management unit, could be embodied, for example, as an ETSI insert in particular with a standard width of 535 mm, as a 23-inch insert and/or as any other insert, in particular for connecting to an, in particular standard, ETSI rack, 23-inch rack and/or any other rack. However, the base unit is advantageously embodied as a 19-inch insert, in particular for connecting to an, in particular standard, 19-inch rack. Furthermore, the base unit is advantageously configured to support at least 144 fiber connections, in particular at least 144 LC simplex port connections whereby each two LC simplex port connections can be used as one LC double port connection, per height unit. Preferably, a port density of the base unit is at least 10 port connections, in particular, at least 50 port connections, advantageously at least 90 port connections, preferably at least 100 port connections, particularly preferably at least 144 port connections or at least 150 port connections per one height unit.

Preferably the frame unit is configured for receiving up to six moveable assemblies and/or further moveable assemblies wherein each of the moveable assemblies and/or further moveable assemblies received in the frame unit is preferably individually movable, in particular with respect to any other moveable assemblies and/or further moveable assemblies and in particular with respect to the frame unit. Moreover, a "moveable assembly" is to be understood as an, in particular movably mounted, unit which is located in a storage position in particular in the receiving space and which is preferably configured for providing and/or supporting a connection functionality and/or a connection capability. In particular, the moveable assembly is embodied as a drawer assembly. Preferably, the moveable assembly and/or the further moveable assembly is configured for guiding, connecting, coupling, terminating and/or distributing at least one cable. Advantageously, the moveable assembly and/or the further moveable assembly extend at least largely over a half width of the base unit. In particular in the storage position the moveable assembly and/or further moveable assembly are arranged at least substantially in a same plane in a side by side position. In addition, the moveable assembly and/or the further moveable assembly could in particular have a height between 10 % and 80 %, preferably between 15 % and 60 % and particularly preferably between 20 % and 40 %, of a height of the base unit. However, preferably the moveable assembly and/or the further moveable assembly has a height of 33 % of a height of the base unit. In addition, the moveable assemblies and/or the further moveable assemblies are preferably located in particular in two columns adjacent to each other and in three rows particularly preferably one above the other. The moveable assembly and/or the further moveable assembly has/have in particular each a modular structure. By the expression "having a modular structure" is herein to be understood, in particular, that the moveable assembly and/or the further moveable assembly itself and/or at least one structural component of the moveable assembly and/or the further moveable assembly has a modular structure and/or is implemented in such a way that it can be assembled modularly, for example like in a construction kit. In particular, herein at least one structural component of the moveable assembly and/or the further moveable assembly can be replaced by at least one further structural component.

Particularly preferably, at least the moveable assembly and at least the further moveable assembly, in particular the plurality of moveable assemblies and/or further moveable assemblies, are releasable from, connectable to and/or replaceable by each other individually and which can be at least largely embodied at least substantially identical to each other. Advantageously, the moveable assembly and/or the further moveable assembly are herein extendable and/or reducible in any required way.

The base unit can comprise at least one guiding unit. The guiding unit can be a part of the frame unit. Advantageously, the guiding rail is part of the guiding unit. The guiding unit can comprise at least two guiding rails, in particular a plurality of guiding rails. However, preferably the guiding unit comprises at least three guiding rails. In particular, the guiding unit has as many guiding rails as moveable assemblies can be arranged about one another inside the frame unit. Preferably the guiding unit is configured for receiving at least the moveable assembly and/or at least the further moveable assembly, wherein each of the moveable assemblies received in the guiding unit is preferably individually movable parallel to an insertion direction of the moveable assembly along at least the guiding rail, in particular with respect to any other moveable assembly and in particular with respect to the guiding unit. Preferably, the move direction of the movable unit is parallel to the insert direction. In particular, the move direction can be formulated as an insert direction of the movable unit.

Particularly preferably, the cable management has at least one further guiding unit, which is constructed identical to the guiding unit. In particular, the guiding unit and the further guiding unit delimit the receiving space for the moveable assembly and/or at least the further moveable assembly. In particular, in the storage position the moveable assembly and/or the at least further moveable assembly is/are arranged between the guiding unit and the further guiding unit. The further guiding unit can have at least a further guiding rail. In the storage position, the moveable assembly can be arranged in the guiding rail and the further guiding rail. In particular, the moveable assembly is moveable parallel to the insertion direction along the guiding rail and the further guiding rail.

By the expression that the fixing unit is movable "parallel to the move direction, in particular to the insertion direction" is herein to be understood, that the fixing unit is movable in the direction of move, in particular insertion, and against the direction of move, in particular insertion. The insert direction is a direction in which the moveable assembly, in particular the movable unit and/or the fixing unit, is inserted into at least the guiding rail, in particular into at least the guiding unit, preferably into the frame unit. Furthermore, by a "storage position" is to be understood, in particular, an in particular mechanically defined position, preferably with respect to the frame unit, of the moveable assembly and/or the further moveable assembly, in which a normal operation takes place and/or in which a processing, e.g. a maintenance, a new cabling, a patching and/or a splicing, is limited to a large extent. In particular, in the storage position the moveable assembly and/or the further moveable assembly is at least largely and preferably completely located and/or inserted in the receiving space of the base unit. In particular, in the storage position the moveable assembly is fixed and/or locked in at least the guiding rail. Advantageously, if the moveable assembly is in the storage position, the fixing unit is in a rest position. Preferably, the rest position, is a position, in which at least the movable unit is fixed in at least the guiding rail.

The fixing unit is used for a reversibly fixing the movable unit in the guiding rail. The moveable assembly can comprise at least a further fixing unit for reversibly fixing the movable unit in at least the further guiding rail. In particular, instead of the rest position, in the release position the movable unit is unfixed in the guiding unit. Particularly preferably, in the release position the movable unit is only partly located and/or inserted in the receiving space.

In this context, "configured" is to mean specifically programmed, designed and/or equipped. By an object being configured for a certain function, it is to be understood that the object fulfills and/or implements this certain function in at least one application state and/or operating state

An extension of the fixing unit can be smaller than an extension of the movable unit. For the purpose of improving a comfort, in particular a handling for a user, and/or a construction, it is proposed that the extension of the fixing unit is greater than the extension of the movable unit when viewed in depth direction. In particular, the extension of the fixing unit is by at least 5 %, advantageously by at least 10 %, preferably by at least 20 %, particularly preferentially by at least 30 % and especially advantageously of maximally 60 % greater than the extension of the movable unit. In particular, the extension of the movable unit and/ or the fixing unit is a longitudinal extension. In this case. a "longitudinal extension" of an object is to be understood as an extension of the object in a longitudinal extension direction of the object. Herein, the "longitudinal direction" of the object is a direction which is parallel to a longest edge and/or side of a smallest, in particular imaginary, cuboid which just encloses the object.

Further, it is proposed that the fixing unit has at least one operating element, which can be pulled or pushed parallel to the move direction, in namely the insertion direction, to release the movable unit from the guiding rail. In this way, a flexibility, construction and/or a fixation can be further improved. Moreover, due to an operating element, which can be pulled or pushed, a comfort, in particular a handling for a user, can be optimized. This in turn can provide a simple and efficient releasing of the movable unit from the guiding rail.

The operating element can be designed as a front handle. Preferably, the operating element extends beyond the movable unit when viewed in depth direction. By pushing or pulling the operating element, the movable unit can be movable from the storage position into the release position. The expressions "above", "under", "front", "rear", "side", "left", "right", "top", "bottom" are to be understood with respect to an orientation of the base unit and/or the movable assembly, in particular the movable unit and/or the fixing unit, in the storage position.

Advantageously, the fixing unit has at least one further operating element, which is arranged relative to the operating element on an opposite side of the movable unit. Thereby, an improved flexibility and/or comfort may be achieved, wherein a fixing unit in particular be individually usable and/or adapted to different needs of users. Due to two operating elements on different sides of a movable unit, a flexibility of the user to release the movable unit from the guiding rail can be improved. In addition, preferably at least four mechanism options for releasing the movable unit can be provided for the user, in particular pushing and pulling the fixing unit parallel to an insertion direction.

The further operating element can be pulled or pushed parallel to the insertion direction to release the movable unit from the guiding rail. Advantageously, the further operating element is designed as a rear handle. By pushing or pulling the further operating element, the movable unit can be movable from the storage position into the release position.

Particularly preferably, a mechanism for releasing the movable unit from the guiding rail comprises at least four options; front pull, front push, rear pull and rear push. For example, the operating element and the further operating element could be simultaneously pushed or pulled. Preferably, it is sufficient that only one of the operating elements, in particular the operating element or the further operating element, has to be pushed or pulled to release the movable unit from the guiding rail.

The operating element and the further operating element can be at least substantially identical objects. The phrasing "at least substantially identical objects" is to mean, in this context, objects which advantageously have the same structure but may at least partially differ in particular as regards their functionality and/or their arrangement on another object. However, preferably the at least substantially identical objects are identical aside from manufacturing tolerances and/or within the range of standardized tolerances.

It is proposed that the operating element can only be pulled parallel to the move direction to release the movable unit in a pull direction, wherein if the movable unit is in a storage position and the operating element is pushed parallel to the move direction, the operating element is intended to block a movement of the movable unit in a push direction. This can prevent a movable unit from falling out/pulling back in an uncontrolled manner. Further, in this way a safety and user comfort can be increased. Moreover, a thin, small and compact design of a fixing unit can be provided.

The fixing unit can comprise at least one blocking element. The blocking element can be flexible for deforming by pushing and/or pulling the operating element and/or the further operating element. By pulling the operating element in the pull direction, the blocking element can be stretched and the movable unit can be released from the guiding rail. In particular, by pulling the operating element in the pull direction, the movable unit can be released from the storage position. Preferably, by pulling the operating element parallel to the move direction, the movable unit can be transferred from the storage position into a service position. In particular, in the service position the moveable assembly is at least partially arranged between the guiding unit and the further guiding unit. In the service position the movable unit can be at least partially inserted in the guiding rail and at least partially protrude from the guiding rail, in particular be pulled out of the guiding rail. If the movable unit is in the service position, a comfortable access to the movable unit can be provided while minimizing physical disturbance of the surrounding cables. Further, an easy and comfortable handling of cables can be achieved, wherein cables, in particular patch cables, in particular the plurality of cables, can be pulled out or pushed in the movable unit while the movable unit is in the service position.

Advantageously, the movable unit is locked in the service position, in particular an uncontrolled movement of the movable unit is blocked. For transferring the movable unit from the service position into the storage position, the operating element can be pushed in the push direction, in particular parallel to the move direction. By pushing the operating element, the movable unit can slide along at least the guiding rail and can be transferred from the service position to the storage position. When the movable unit is in the storage position, the movable unit can be transferred in the service position by pulling the operating element in the pull direction. By pulling the operating element the movable unit can slide along at least the guiding rail and can be transferred from the storage position to the service position.

By pushing the operating element in the push direction, the blocking element can be compressed for blocking the movement of the movable unit, when the movable unit is in the storage position. The blocking element can comprise a blocking nose. When the movable unit is in the storage position and the operating element is pushed in the push direction, the blocking element can be deformed, preferably compressed, and the blocking nose can block the movement of the movable unit in the push direction and thus prevents the movable unit from slipping out and/or falling out from the guiding rail in the push direction. Preferably, the guiding rail comprises at least one notch. The notch can be arranged on a bottom side of the guiding rail. In particular, when the movable assembly is at least partially arranged in the receiving space, in particular in the service and/or the storage position, the movable unit is arranged between two guiding bars of the guiding unit, advantageously between an upper bar and a lower bar. Preferably, the upper bar comprises at least the notch. Further, the movable unit can contact the lower bar, in particular can lay on the lower bar, when the movable unit is at least partially arranged in the receiving space, in particular in the service and/or the storage position. When the movable unit is in the storage position and the operating element is pushed in the push direction, the blocking element can be deformed, preferably compressed, and the blocking nose can contact the notch and can stick in the notch for blocking the movement of the movable unit in the push direction.

In a preferred implementation of the invention, it is proposed that the fixing unit is bar-shaped. In this way, a compact, narrow and/or efficient construction and/or design can be provided. In particular, the fixing unit is plate-shaped. By the fact that an object is "bar-shaped/plate-shaped", in particular, it is to be understood that at least one smallest possible geometric cuboid, which just completely encloses the object, is bar-shaped/plate-shaped. Advantageously, the longitudinal extension of the fixing unit is greater than a width extension of the fixing unit. In particular, the longitudinal extension of the fixing unit is by at least 20 %, advantageously by at least 50 %, preferably by at least 70 %, particularly preferentially by at least 80 % greater than the width extension of the fixing unit.

Further, it is proposed that a total width extension of the fixing unit is maximum 10 mm. In this way, a compact, narrow and/or efficient construction and/or design of at least a fixing unit, in particular a movable assembly, can be provided. Advantageously, the fixing unit has a width extension, in particular a thickness, of maximally 8 mm, particularly advantageously of maximally 5 mm. A "width extension" of an object shall be understood in this context, as an extension of the object in a width direction of the object. The "width direction" of the object is a direction which is parallel to a second longest edge and/or side of a, in particular of said, smallest, in particular imaginary, cuboid which just encloses the object.

Additionally, it is proposed that the fixing unit comprises a resetting unit for transferring the fixing unit from the release position into a rest position. In this way, a fixation can be improved, wherein a movable unit can be securely locked in a guiding rail. Moreover, a compact, narrow and/or efficient construction and/or design can be provided. The fixing unit can be arranged in a housing element of the movable unit. Advantageously, the fixing unit and the housing element, which surrounds the fixing unit at least in sections, have a width extension, in particular a thickness, of maximally 15 mm, particularly advantageously of maximally 12 mm, preferably of maximally 10 mm and particularly preferably of maximally 8 mm. The resetting unit can cooperate with the housing element or with at least one element of the housing element for transferring the fixing unit from the release position into a rest position. In particular, the movable unit is made in a one-piece embodiment.

For the purpose of improving a fixation and/or a flexibility, it is proposed that the resetting unit comprises at least one spring element, which is implemented for transferring the fixing unit from the release position into the rest position. Advantageously, at least the spring element is an elastic, in particular spring-elastic element. The spring element can be made at least partially or to a great part or completely from a mineral and/or a plastic and/or a metal, in particular spring steel or a stainless steel. In particular, the spring element cooperates with the housing unit. The housing unit can have at least one stopping element. Preferably, the spring element is arranged around the stopping element. The spring element can cooperate with the stopping element for transferring the fixing unit from the release position into the rest position. In particular, the spring element is flexible and/or movable.

Preferably, the resetting unit comprises at least one further spring element, which is implemented for transferring the fixing unit from a further release position into the rest position. In this way, the fixation and/or a flexibility can be further improved. In addition, a simple and compact construction and/or design can be provided, which allows transferring a fixing unit from a further release position into a rest position. In particular, the further spring element cooperates with the housing unit. The housing unit can have at least one further stopping element. Preferably, the further spring element is arranged around the further stopping element. The further spring element can cooperate with the further stopping element for transferring the fixing unit from the further release position into the rest position. In particular, the further spring element is flexible and/or movable. Advantageously, at least the further spring element is an elastic, in particular spring-elastic element. The further spring element can be made at least partially or to a great part or completely from a mineral and/or a plastic and/or a metal, in particular spring steel or a stainless steel. Possibly, the spring element and further spring element could be formed differently. Particularly preferably, the spring element and the further spring element are at least substantially identical objects.

Moreover, it is proposed that the fixing unit comprises a latch, which is arrangeable in a recess of the guiding rail for fixing the movable unit to the guiding rail. In this way, a securely and preferably automatically locking/fixing of a movable unit in a guiding rail can be provided, so that in general fixation can be further improved. In addition, a simple and compact construction and/or design can be provided and furthermore, a security and/or a comfort, in particular a user comfort, can be increased. Due to the arranged latch in the recess, the fixing unit can fix the movable unit in the guiding rail. In particular, if the movable assembly is in the storage position, the latch is arranged in the recess and fixed the movable unit in the guiding rail. Preferably, is the movable assembly in the storage position, the fixing unit is in the rest position. In the rest position and in the storage position, the movable unit can be locked in at least the guiding rail. By insertion the movable assembly, in particular at least the movable unit, along the insertion direction into at least the guiding rail, the movable assembly can be automatically locking with the guiding rail. For example, a user has to slide the movable assembly both forwards or backwards until feeling a "click" and impossibility to move it further. In particular, this means the movable assembly is automatically and securely locked in-place, and particularly preferably, the latch is arranged in the recess.

For the purpose of improving a flexibility and/or a simple and/or efficient and/or compact construction, it is proposed that the fixing unit comprises at least one flexible arm connected to the latch and to a body element of the fixing unit. The fixing unit can have a further flexible arm connected to the latch and to the body element. In particular, the further flexible arm is arranged relative to the flexible arm on an opposite side of the latch. Advantageously, the latch is held by the flexible arm and the further flexible arm. Preferably, the latch and the body element are not directly connected to each other. In particular, the latch and the body element are arranged contactless to each other in the rest position.

Further, it is proposed that the flexible arm is deformed when the fixing unit is in the release position. In this way, a simple and/or efficient way of releasing a fixing unit can be provided. Thereby an enhanced flexibility can be achieved. In particular, the flexible arm is being compressed due to the front push and/or rear pull. Advantageously, due to the front push and/or rear pull the latch is movable out of the recess. By deforming at least the flexible arm the latch can be movable out of the recess. If the latch is lifted in the release position, the movable unit can be movable out of at least the guiding rail. In particular, the further flexible arm is being compressed due to the front pull and/or rear push. Advantageously, due to the front pull and/or rear push the latch is movable out of the recess. By deforming at least the further flexible arm the latch can be movable out of the recess.

It is also proposed that the fixing unit is made in a one-piece embodiment. In this way, a construction can be further improved. By such a design/construction of a fixing unit, an efficiency, in terms of product and/or labor and/or assembly and/or manufacturing and/or cost efficiency, can be increased. By "made in a one-piece embodiment" is in particular to mean, connected at least by substance-to-substance bond, for example by a welding process, a gluing process, an injection-molding process, and/or another process that is deemed expedient by someone skilled in the art and/or advantageously formed in one piece, like for example by a production from a cast and/or by a production in a one-component or multi-component injection-molding procedure, and advantageously from a single blank.

Furthermore, it is proposed that, the fixing unit is symmetrical with respect to a symmetry plane, which is perpendicular to the insertion direction. Thereby a simple, efficient and/or and comfortable construction can be provided. Further, an improved flexibility and/or user comfort may be achieved, wherein a fixing unit may in particular be individually usable to different needs of users. Moreover, efficiency in a manufacturing process can be increased, as this symmetry is for the DFM (Design For Manufacturability) and can reduce costs. Due to the symmetrically fixing unit, preferably at least four mechanism options for releasing the movable unit can be provided for the user, in particular pushing and pulling the fixing unit parallel to an insertion direction. The term that a plane is perpendicular to another plane is to be understood, that the plane and the other plane include a 90° angle and the angle has a maximum deviation of in particular less than 8°, advantageously less than 5° and especially advantageously less than 2°. In particular, the fixing unit is symmetrical with respect to the latch. The latch can be the center of a symmetry axis inside the symmetry plane.

In another aspect of the invention, which can in particular be considered in combination with as well as separately from other aspects of the invention, a method for releasing a movable assembly, in particular the above-mentioned movable assembly, from a guiding rail of a base unit, in particular the above-mentioned base unit, wherein a fixing unit is moved parallel to a move direction, in particular an insertion direction, of a movable unit into a release position in order to release the movable unit from a guiding rail of the base unit. By means of such a method an enhanced flexibility regarding a releasing and/or a fixation can be achieved. This allows achieving a particularly flexible movable assembly, in particular without affecting other movable assemblies and/or further movable assemblies during movement of one movable assembly and/or fixing the movable assembly. Furthermore, a handling can be simplified. In addition, a comfort, in particular a user comfort, can be increased. Additionally, in turn of a fixing unit which is movable parallel to an insertion direction of the movable unit, a simple and efficient fixation and/or releasing can be provided. Due to the fixing unit which is movable parallel to the insertion direction, preferably at least two mechanism options for releasing the movable unit can be provided for the user, in particular pushing and pulling the fixing unit.

Herein the drawer system and/or the fixing unit and/or the moveable assembly and/or the base unit and/or the method is/are not to be limited to the application and implementation described above. In particular, for the purpose of fulfilling a functionality herein described, the drawer system and/or the fixing unit and/or the moveable assembly and/or the base unit and/or the method may comprise a number of respective elements, structural components and/or units and/or method steps that differs from the number mentioned herein. Furthermore, regarding the value ranges mentioned in this disclosure, values within the limits mentioned are to be understood to be also disclosed and to be used as applicable.

### Drawings

Further advantages may become apparent from the following description of the drawings. In the drawings two exemplary embodiments of the invention are shown. The drawings, the description and the claims contain a plurality of features in combination. The person having ordinary skill in the art will purposefully also consider the features separately and will find further expedient combinations.

If there is more than one specimen of a certain object, only one of these is given a reference numeral in the figures and in the description. The description of this specimen may be correspondingly transferred to the other specimens of the object.

It is shown in:
- Fig. 1: a schematic view of a drawer system having at least one base unit, which comprises at least one moveable assembly,
- Fig. 2: a perspective view of the base unit having a guiding unit with at least one guiding rail in which the moveable assembly is arranged,
- Fig. 3: a perspective top view of the moveable assembly comprising a fixing unit and a movable unit,
- Fig. 4: a detail view of a latch of the fixing unit,
- Fig. 5: a detail view of the guiding unit,
- Fig. 6: a sectional view of the moveable assembly arranged in the guiding rail,
- Fig. 7: a detail view of the fixing unit,
- Fig. 8: a detail view of the assembled fixing unit on the movable unit of the moveable assembly,
- Fig. 9: a diagram of a method for releasing the moveable assembly from the guiding rail,
- Fig. 10: a movement of the latch to release the movable unit from the guiding rail when pushed an operating element of the fixing unit,
- Fig. 11: a movement of the latch to release the movable unit from the guiding rail when pulled the operating element,
- Fig. 12: a perspective top view of a moveable assembly comprising at least one fixing unit and a movable unit in a further embodiment of the invention,
- Fig. 13: a sliced view of the fixing unit arranged in the movable unit according to figure 12,
- Fig. 14: a detailed view of the fixing unit according to figures 12 and 13 and
- Fig. 15: a detailed view of a guiding unit comprising at least one guiding rail for receiving the movable assembly according to figures 12 to 14.

### Description of the exemplary embodiments

The following figures are schematic and not true-to-scale representations.

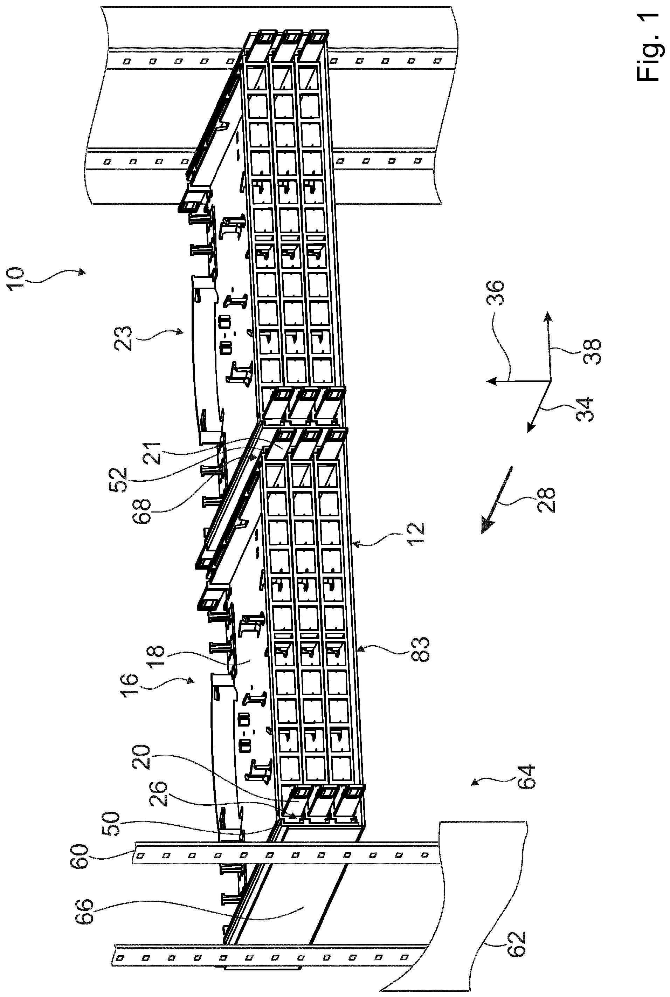

Figure 1 schematically shows a drawer system 10 which is embodiment in this present case as a cable management system. Alterative and/or additional the drawer system 10 can be part of a household system, wherein the household system can comprise at least one item of household furniture and/or household appliance. Moreover, the drawer system 10 can be used for example in a pharmacy and/or in a workshop and/or in a doctor's office and/or in a medical practice and/or in a hospital. The drawer system 10 can be used wherever a drawer system is needed. In this present case, the description of the invention is carried out on the basis of a drawer system 10 embodied as the said cable management system (cf. figure 1).

The drawer system 10 is implemented as a network cabinet 62 with a rack 60. The drawer system 10 is configured for managing cables, which can be embodied as optical waveguide cables. However, it is also conceivable to use cables that differ from optical waveguide cables, e.g. electric cables.

The drawer system 10 comprises at least one base unit 12. In this present case the base unit 12 is embodied as a cable management unit. In the present case for the sake of clarity, only one base unit 12 is shown, but the drawer system 10 can also comprise a plurality of base units 12. If the drawer system 10 comprises the plurality of base units 12, the base units 12 can be located one above the other and can be at least substantially identical to each other. Moreover, the base units 12 can be releasable from, connectable to and/or replaceable with each other individually. The following description will be restricted to one of the base units 12, wherein, due to the at least substantially identical construction of the base units 12, the following description may also apply to possible other base units 12.

The base unit 12 is in the present case embodied as a 19-inch insert. The base unit 12 is intended to be used in a carrier unit 64 of the drawer system 10, in the present case in the rack 60. Herein, the base unit 12 is installed horizontally. The base unit 12 has a height of one height unit (U). The base unit 12 comprises a fiber connection density of at least 144 connections per height unit (U), wherein other values of connections per height unit are possible, such as at least 10 port connections, at least 50 port connections, at least 90 port connections or at least 150 port connections.

Furthermore, figure 1 shows that the base unit 12 comprises at least one moveable assembly 16. In this present case, the moveable assembly 16 is embodied as a drawer unit for insertion into the base unit 12. The base unit 12 can also comprise at least one further moveable assembly 23, wherein the base unit 12 can have a plurality of moveable assemblies 16, 23, in particular a plurality of moveable assemblies 16 and/or further moveable assemblies 23. In the present case, the base unit 12 comprises six moveable assemblies 16, 23 in total, wherein for the sake of clarity in figure 1 only one moveable assembly 16 and one further moveable assembly 23 comprise a reference numeral. The moveable assembly 16 and the further moveable assembly 23 are located adjacent to each other. The moveable assembly 16 and the further moveable assembly 23 are at least substantially identical to each other. Moreover, the moveable assembly 16 and the further moveable assembly 23 are individually releasable, connectable to and/or replaceable. The following description will be restricted only to the moveable assembly 16, wherein, due to the at least substantially identical construction of the moveable assemblies 16, 23, the following description may also apply to possible other moveable assemblies.

In a storage position at least the moveable assembly 16 is arranged in a receiving space 83 of the base unit 12. The base unit 12 comprises a frame unit 66 (cf. figure 1). The frame unit 66 is embodied as a chassis. The frame unit 66 forms an outer housing of the base unit 12. The frame unit 66 is in the present case made of metal, in particular metal sheets. Alternatively, the frame unit 66 may be made at least partly of a plastic material.

The base unit 12 has six receiving spaces 83 (cf. figure 1). The six receiving spaces 83 are arranged in two columns besides each other. The frame unit 66 defines and/or delimits the receiving spaces 83. The receiving space 83 is configured for receiving one moveable assembly 16 or one further moveable assembly 23. The receiving spaces 83 have the same dimensions. The moveable assembly 16 fits into the receiving space 83. The further movable unit 18 fits also into the receiving space 83. The frame unit 66 is configured for receiving up to three moveable assemblies 16 and up to three further drawing units 23. The moveable assemblies 16 and/or the further moveable assemblies 23 received in the frame unit 66 are positioned in a storage position. The moveable assemblies 16 and/or the further moveable assemblies 18 received in the frame unit 66 are positioned over and/or besides each other.

In the present case three moveable assemblies 16 are placed one above each other in a stack (cf. figure 1). Further, three further moveable assemblies 23 are placed one above each other in a stack. As shown in figure 1, all moveable assemblies 16, 23 are in the storage position.

The frame unit 66 comprises at least one guiding unit 50. Further, the frame unit 66 has at least one further guiding unit 52. In the present case, the guiding unit 50 and the further guiding unit 52 defines and/or delimits the receiving spaces 83. The frame unit 66 can comprise a plurality of guiding units 50, 52, at least four guiding units 50, 52 in total. The base unit 12 is symmetrical. Therefore, the following description will be restricted to the guiding unit 50 and the further guiding unit 52.

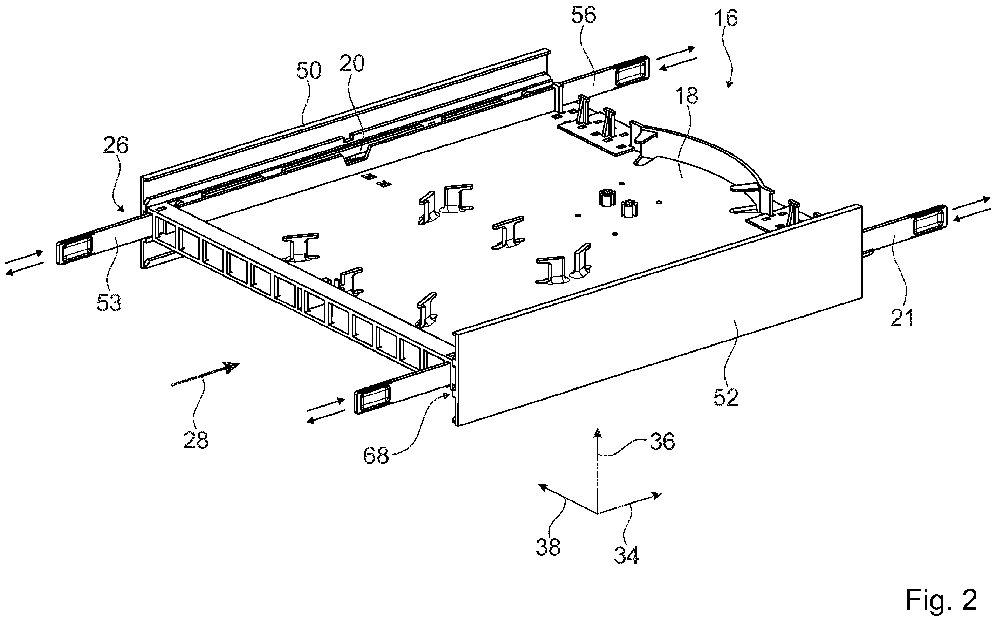

In this case the guiding unit 50 and the further guiding unit 52 defines and/or delimits the receiving spaces 83 for at least the moveable assembly 16. As shown in figures 1 and 2 at least the moveable assembly 16 is arranged between the guiding unit 50 and the further guiding unit 52. The base unit 12 comprises at least one guiding rail 26. The guiding rail 26 is a part of the guiding unit 50. In the present case, the guiding unit 50 comprises three guiding rails 26, wherein for the sake of clarity only one of the guiding rails 26 comprises a reference numeral. Further, the guiding unit 50 comprises at least two bars 106, 108. The guiding rail 26 comprises the two bars 106, 108, namely an upper bar 106 and a lower bar 108. When the movable assembly 16 is at least partially arranged in the receiving space 83, the movable assembly 16 is at least partially arranged between the upper bar 106 and the lower bar 108.

The base unit 12 comprises at least one further guiding rail 68. The guiding rail 68 is a part of the further guiding unit 52 (cf. figures 1 and 2). In the present case, the further guiding unit 52 comprises three further guiding rails 68, wherein for the sake of clarity only one of the further guiding rails 68 comprises a reference numeral.

The moveable assembly 16 received in the frame unit 66, in particular in the guiding unit 50 and in the further guiding unit 52 is movable from the storage position into a release position and vice versa. Each of the moveable assemblies 16 and/or the further moveable assemblies 23 is individually movable with respect to any other moveable assemblies 16 and/or the further moveable assemblies 23. Each of the moveable assemblies 16 and/or the further moveable assemblies 23 is individually movable with respect to the frame unit 66, from a storage position (cf. figure 1) into the release position and vice versa.

The moveable assembly 16 is movable in a linear motion with respect to the frame unit 66. The moveable assembly 16 is movable parallel to an insertion direction 28. This means, that the moveable assembly 16 is movable in the insertion direction 28 and against the insertion direction 28. The moveable assembly 16 is movable parallel to an insertion direction 28 along the guiding rail 26. The moveable assembly 16 is movable parallel to an insertion direction 28 along the further guiding rail 68 (cf. figure 2). For a better understanding a coordination cross, in particular a height direction 36, a width direction 38 and a depth direction 34 are shown in figures 1 to 3. The insertion direction 28 is parallel to the depth direction 34 (cf. figures 1 and 2).

The moveable assembly 16 comprises at least one movable unit 18 and at least one fixing unit 20 for reversibly fixing the movable unit 18 in the guiding rail 26. The fixing unit 20 is movable parallel to the insertion direction 28 of the movable unit 18 into the release position in order to release the movable unit 18 from the guiding rail 26 (cf. figure 2).

The moveable assembly 16 comprises at least one further fixing unit 21 for reversibly fixing the movable unit 18 in the further guiding rail 68. The further fixing unit 21 is movable parallel to the insertion direction 28 of the movable unit 18 into the release position in order to release the movable unit 18 from the further guiding rail 68 (cf. figure 2). The following description will be restricted to the fixing unit 20, wherein, due to the at least substantially identical construction of the fixing unit 20 and the further fixing unit 21, the following description may also apply to possible at least the further fixing unit 21. Further, it is conceivable that the fixing unit 20 and the further fixing unit 21 are connected by a link or handle joining of the moveable assembly 16. This would allow a movement of one of the fixing units 20, 21 to be transferred to the other fixing unit 20, 21 in each case.

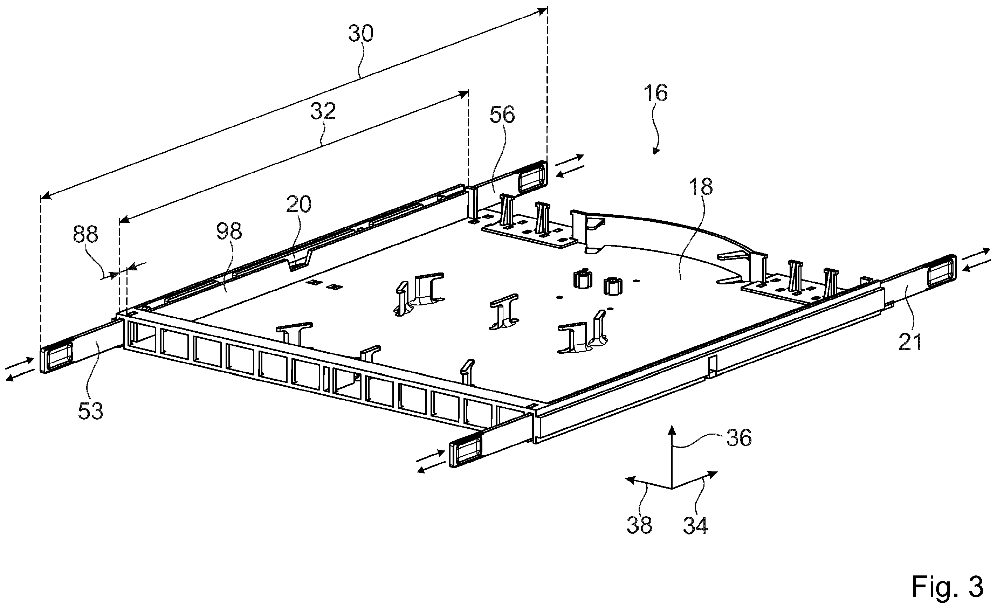

As shown in figure 3, an extension 30 of the fixing unit 20 is greater than an extension 32 of the movable unit 18 when viewed in depth direction 34. The fixing unit 20 has at least one operating element 53, which can be pulled or pushed parallel to the insertion direction 28 to release the movable unit 18 from the guiding rail 26. The operating element 53 is designed as a front handle. The fixing unit 20 has at least one further operating element 56, which is arranged relative to the operating element 53 on an opposite side of the movable unit 18. The further operating element 56 can be pulled or pushed parallel to the insertion direction 28 to release the movable unit 18 from the guiding rail 26. The further operating element 56 is designed as a rear handle. In this case, the mechanism for releasing the movable unit 18 from the guiding rail 26 comprises four options; front pull, front push, rear pull and rear push (cf. figures 1 and 2).

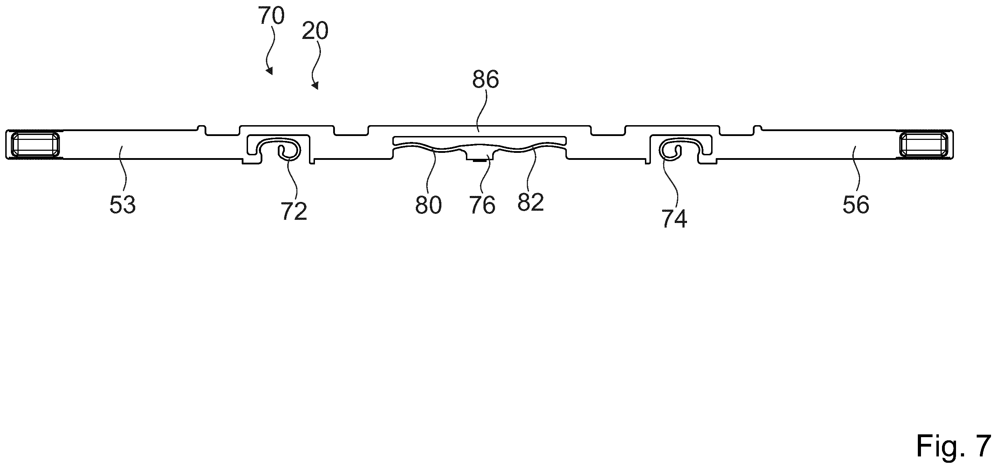

As shown in figure 7, the fixing unit 20 is bar-shaped. The fixing unit 20 is made in a one-piece embodiment. The fixing unit 20 is arranged in a housing element 98 of the movable unit 18 on a side of the movable unit 18. Further, the fixing unit 20 including the housing element 98 has a thickness 88 of maximally 10 mm, advantageously of maximally 8 mm, particularly advantageously of maximally 5 mm. The fixing unit 20 is in the present case made at least partly of material plastic. Alternatively, the fixing unit 20 may be made at least partly of material metal.

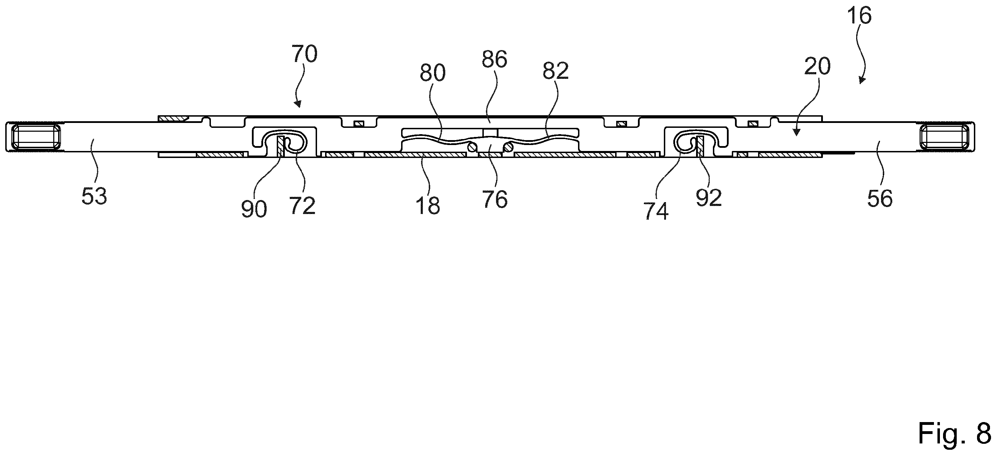

The fixing unit 20 comprises a resetting unit 70 for transferring the fixing unit 20 from the release position into a rest position. Figures 7 and 8 show the rest position of the resetting unit 70. The resetting unit 70 comprises at least one spring element 72, which cooperates with the movable unit 18 for transferring the fixing unit 20 from the release position into the rest position. Whereas figure 7 shows only the fixing unit 20, figure 8 shows the fixing unit 20 arranged in the housing element 98 of the movable unit 18, wherein the housing unit 98 is sliced. The movable unit 18 comprises a stopping element 90. In this case, the stopping element 90 is part of the housing element 98. The spring element 72 is arranged around the stopping element 90. The spring element 72 cooperates with the stopping element 90 for transferring the fixing unit 20 from the release position into the rest position.

The resetting unit 70 comprises at least one further spring element 74, which cooperates with the movable unit 18 for transferring the fixing unit 20 from a further release position into the rest position. The movable unit 18 comprises a further stopping element 92. In this case, the stopping element 92 is part of the housing element 98. The spring element 74 is arranged around the further stopping element 92. The further spring element 74 cooperates with the further stopping element 92 for transferring the fixing unit 20 from the further release position into the rest position.

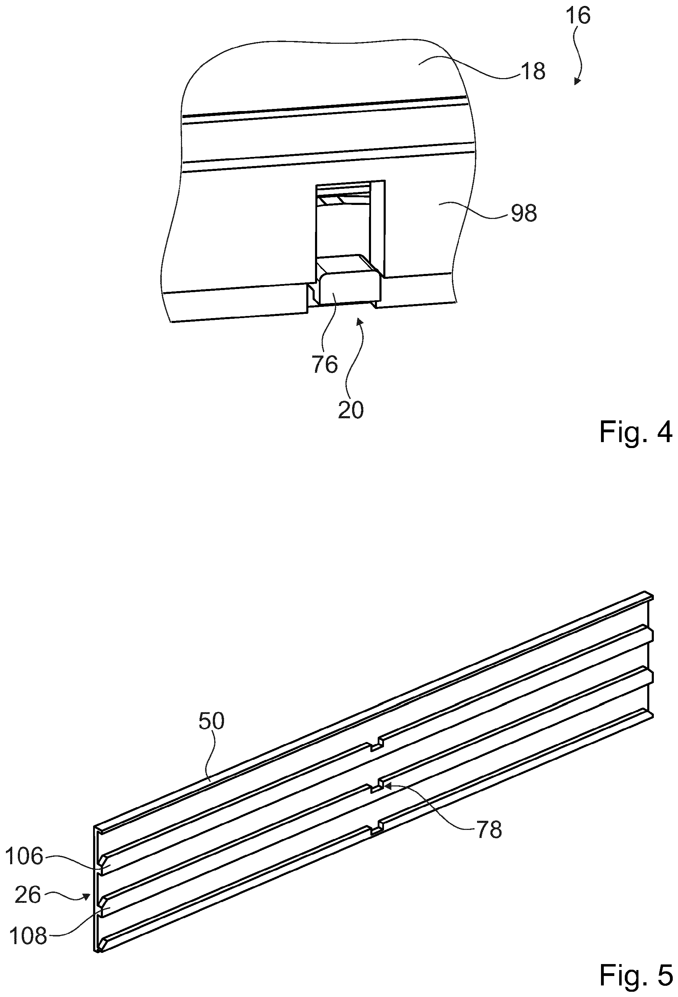

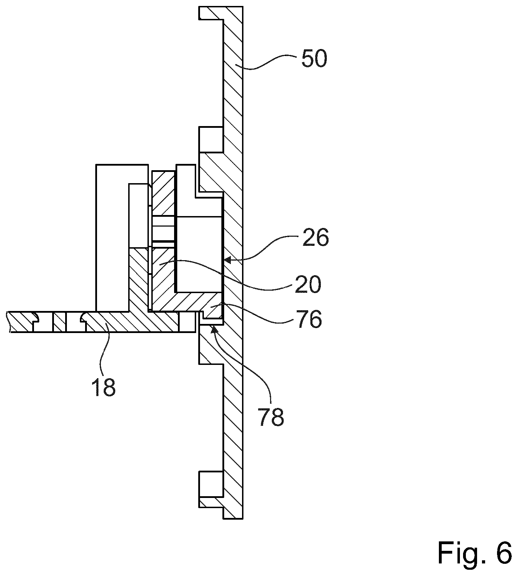

The fixing unit 20 comprises a latch 76, which is arrangeable in a recess 78 of the guiding rail 26 for fixing the movable unit 18 to the guiding rail 26 (cf. figures 4 to 6). Figure 6 shows the situation when the latch 76 is arranged in the recess 78 of the guiding rail 26, so that the moveable assembly 16 is in the storage position. When the moveable assembly 16 is in the storage position, the fixing unit 20 is in the rest position (cf. figure 6). In the rest position and in the storage position, the movable unit 18 is locked in at least the guiding rail 26. By insertion of the moveable assembly 16 along the insertion direction 28 into at least the guiding rail 16, the moveable assembly 16 is automatically locking with the guiding rail 26.

A user has to slide the moveable assembly 16 both forwards or backwards until feeling a "click" and impossibility to move it further. This means the moveable assembly 16 is automatically and securely locked in-place. Moreover, this means that the latch 76 is arranged in the recess 78.

The fixing unit 20 comprises at least one flexible arm 80 connected to the latch 76 and to a body element 86 of the fixing unit 20 (cf. figures 7 and 8). Furthermore, the fixing unit 20 comprises at least one further flexible arm 82 connected to the latch 76 and to the body element 86 of the fixing unit 20. The further flexible arm 82 is arranged relative to the flexible arm 80 on an opposite side of the latch 76. The fixing unit 20 is symmetrical with respect to a symmetry plane, which is perpendicular to the insertion direction 28. In this case, the fixing unit 20 is symmetrical with respect to the latch 76.

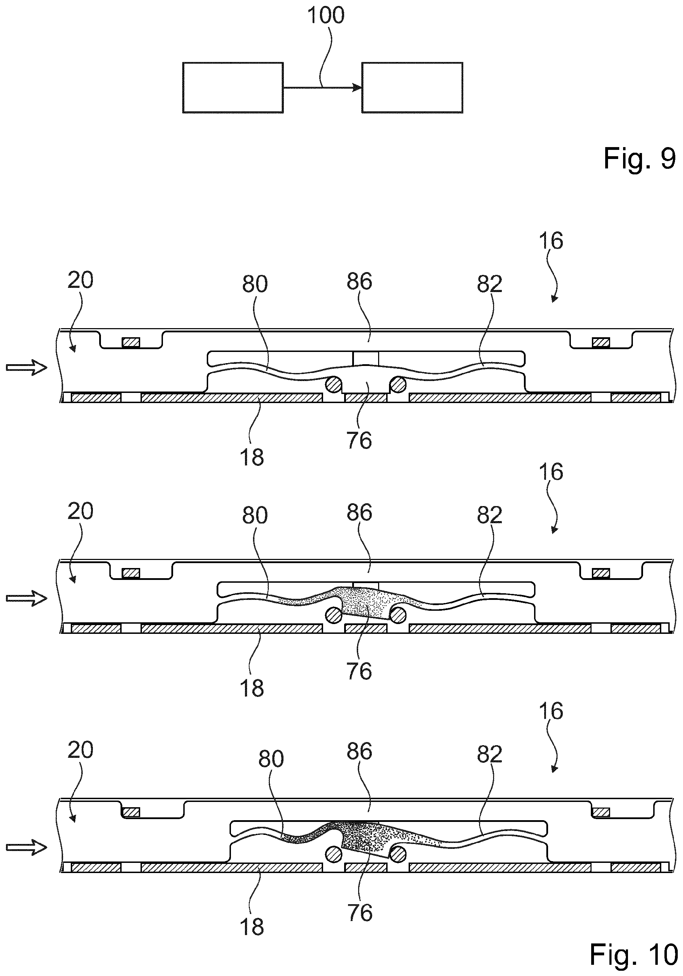

Figure 9 shows a schematic diagram of a method for releasing the moveable assembly 16 from the guiding rail 26, wherein a fixing unit 20 is moved parallel to the insertion direction 28 of the movable unit 18 into the release position in order to release the movable unit 18 from the guiding rail 26 of the base unit 12. The method for releasing the moveable assembly 16 from the guiding rail 26 comprises a releasing step 100, by means of which the method is described in this case.

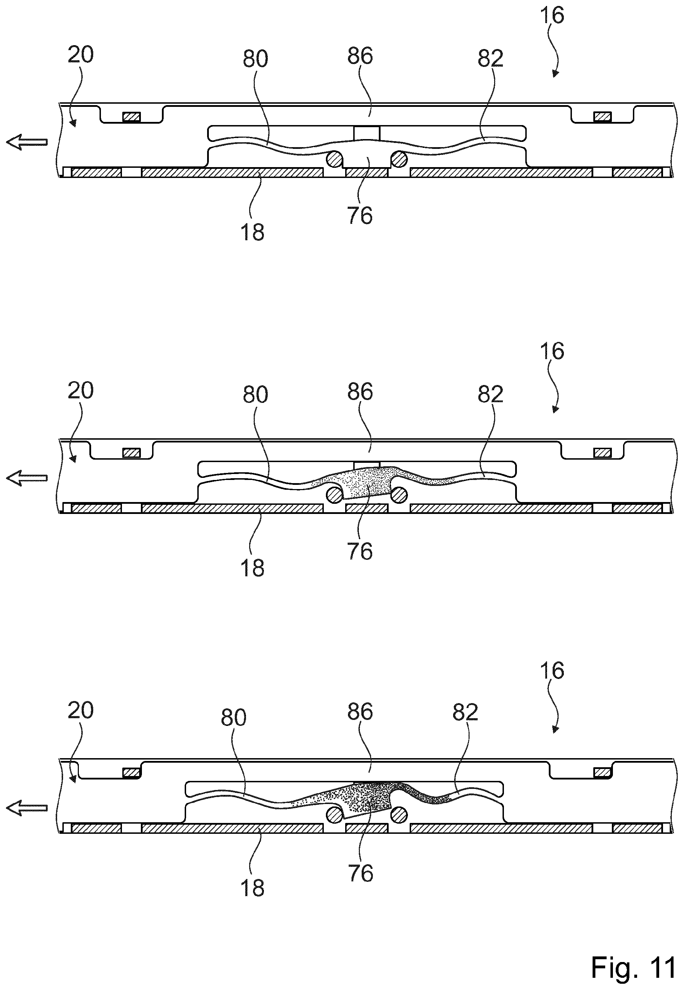

Figures 10 and 11 are intended to illustrate the method for releasing. The mechanism for releasing the movable unit 18 from the guiding rail 26 comprises four options; front pull, front push, rear pull and rear push. For example, figure 10 shows the option of front push, in particular if the operating element 53 is pushed along the insert direction 28. Moreover, figure 11 shows the option of front pull, in particular if the operating element 53 is pulled against the insert direction 28 but parallel to the insertion direction 28.

The latch 76 and the body element 86 are arranged contactless to each other in the rest position (cf. first picture of figures 10 and 11). The flexible arm 80 is being deformed when the fixing unit 20 is in the release position. Figure 10 shows that the flexible arm 80 is being compressed due to the front push. This makes the latch 76 movable out of the recess 78. In the last picture of figure 10, it is shown that the latch 76 is lifted, so that the movable unit 18 can be movable out of at least the guiding rail 26.

Figure 11 shows the option of front pull to release the moveable assembly 16 from the guiding rail 26. In this case, the further flexible arm 82 is being deformed when the fixing unit 20 is in the further release position. Figure 11 shows that the further flexible arm 82 is being compressed due to the front pull. This makes the latch 76 movable out of the recess 78. In the last picture of figure 11, it is shown that the latch 76 is lifted, so that the movable unit 18 can be movable out of at least the guiding rail 26.

For a better understanding of working force to the flexible arm 80, the further flexible arm 82 and/or the latch 76 during deformation, figures 10 and 11 shows different shaded areas which represent areas with different strong deformation forces. A greater force acts on areas with more dots/stronger shading.

Both described options of mechanism for releasing the movable unit 18 from the guiding rail 26 can be transferred to the rear side of the fixing unit 20. The rear pull and the rear push have the same effect to a deforming of the flexible arm 80 and/or the further flexible arm 82.

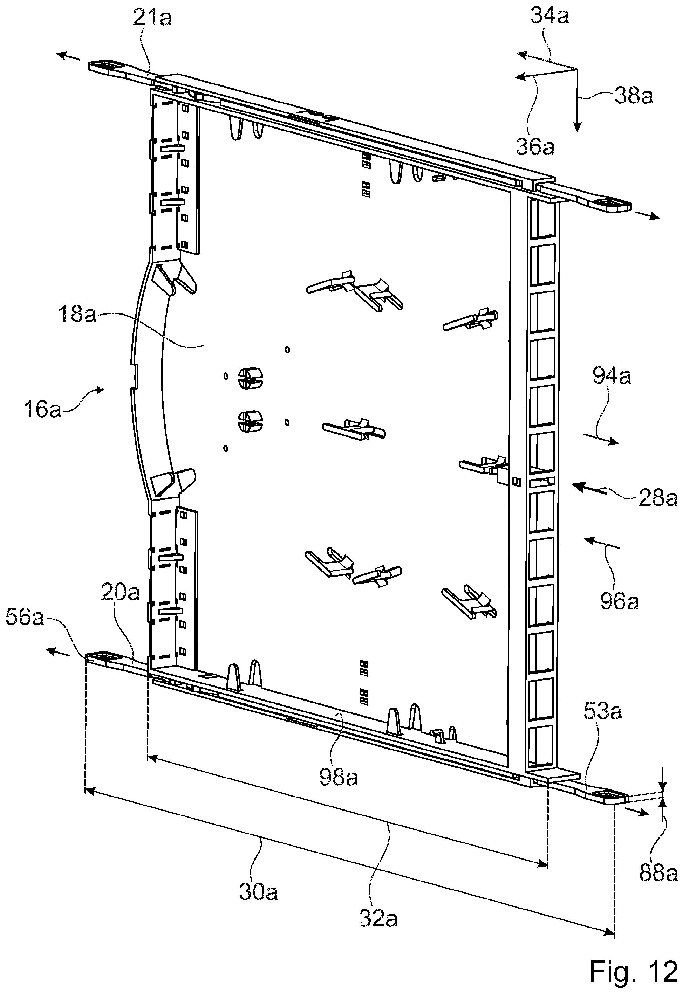

Figures 12 to 15 show a further exemplary embodiment of the invention. The following description is substantially limited to the differences between the exemplary embodiments, wherein regarding structural elements, features and functions that remain the same the description of the other exemplary embodiment, in particular the exemplary embodiment of figures 1 to 11, may be referred to. For distinguishing the exemplary embodiments, the letter "a" has been inserted into the reference signs in the exemplary embodiment of figures 12 to 15. Regarding structural elements having the same denomination, namely regarding structural elements having the same reference signs, principally the drawing and/or the description of the other exemplary embodiment, in particular of the exemplary embodiment of figures 1 to 11, may be referred to.

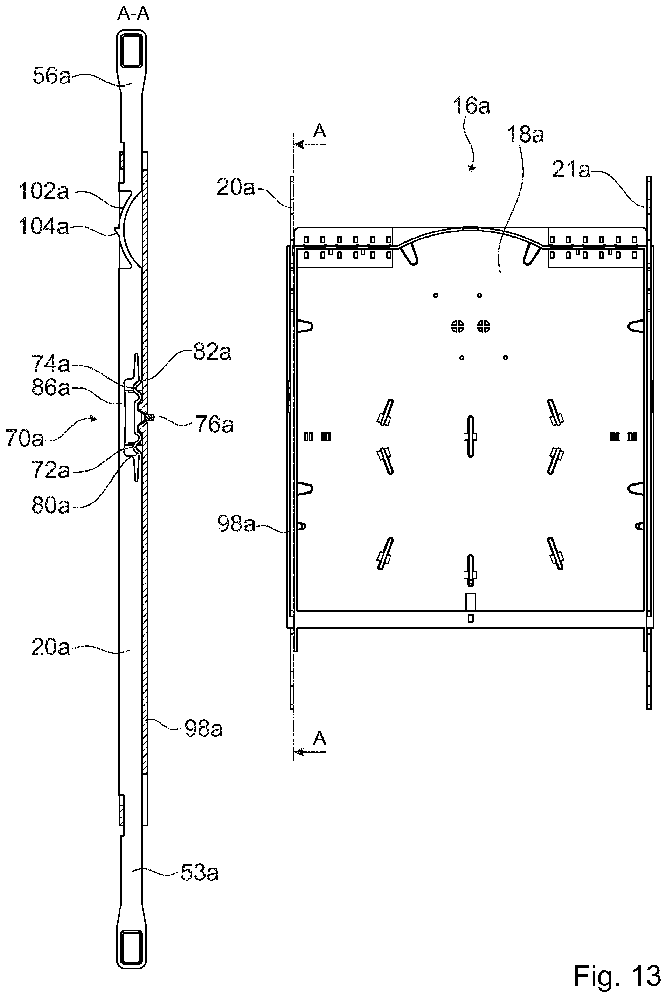

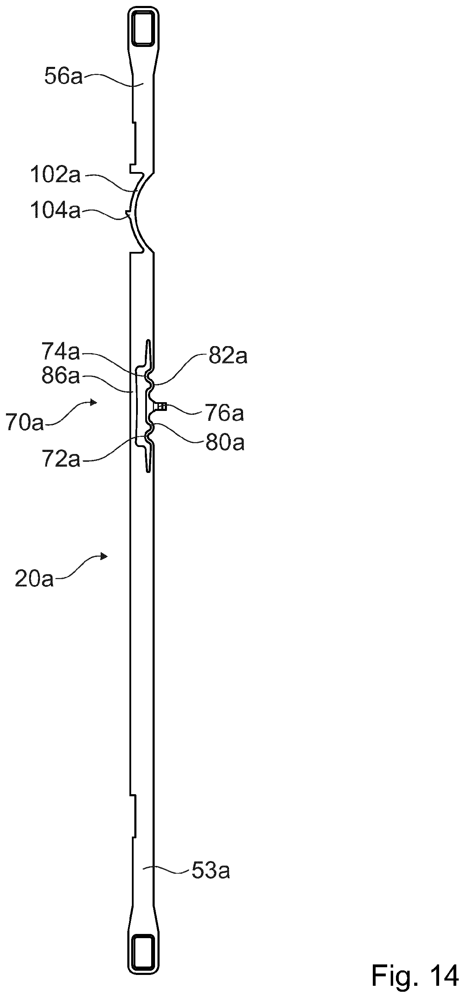

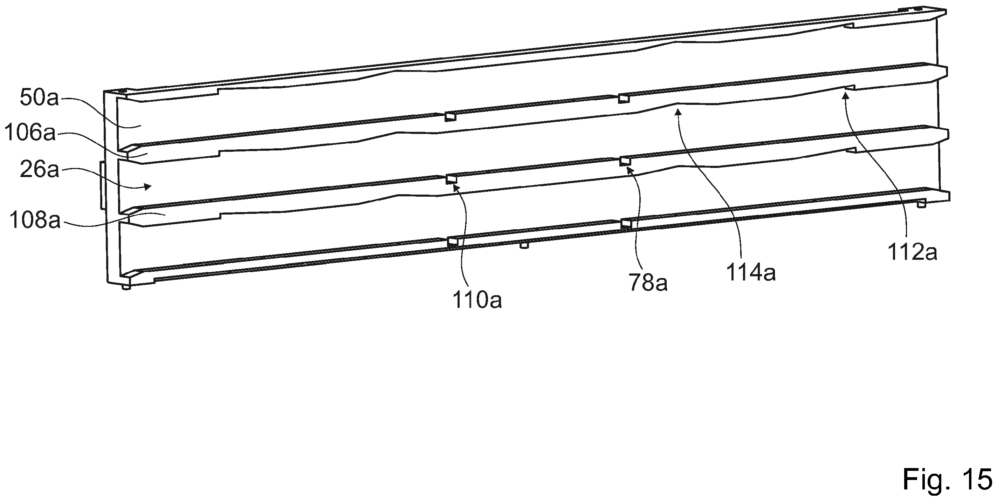

Figure 12 shows a movable assembly 16a which comprises at least one movable unit 18a and at least one fixing unit 20a for reversibly fixing the movable unit 18a in at least one guiding rail 26a of a guiding unit 50a (c.f. figure 15). The fixing unit 20a is movable parallel to a move direction 28a of the movable unit 18a into the release position in order to release the movable unit 18a from the guiding rail 26a. While figures 12 and 13 show the movable assembly 16a comprising the fixing unit 20a arranged in a housing element 98a of the movable unit 16a on a side of the movable unit 18a, figure 14 shows a single and detailed view of the fixing unit 20a. Further figure 15 shows a detailed view of the guiding unit 50.

The embodiment "a" of the figures 12 to 15 distinguishes from the embodiment of figures 1 to 11 by the design and shape of the fixing unit 20a and by a design of the guiding unit 50a.

One difference between these two embodiments is that at least one operating element 53a of the fixing unit 20a can only be pulled parallel to the move direction 28a to release the movable unit 18a in a pull direction 94a, wherein if the movable unit 18a is in a storage position and the operating element 53a is pushed parallel to the move direction 28a, the operating element 53a is intended to block a movement of the movable unit 18a in a push direction 96a.

In this embodiment, the fixing unit 20a comprises a blocking element 102a. The blocking element 102a is flexible for deforming by pushing and/or pulling the operating element 53a and/or a further operating element 56a of the fixing unit 20a. By pulling the operating element 53a in the pull direction 94a, the blocking element 102a is stretched and the movable unit 18a can be released from the guiding rail 26a. Further, by pulling the operating element 53a in the pull direction 94a, the movable unit 18a can be released from the storage position.

The movable unit 18a is arrangeable in a service position. By pulling the operating element 53a parallel to the move direction 28a, the movable unit 18a can be transferred from the storage position into the service position. In the service position the moveable assembly 16a is at least partially arranged between the guiding unit 50a and at least one further guiding unit (not shown). In the service position the movable unit 18a is at least partially inserted in the guiding rail 26a and at least partially protrudes from the guiding rail 26a. If the movable unit 16a is in the service position, a comfortable access to the movable unit 16a can be provided while minimizing physical disturbance of surrounding cables. Further, an easy and comfortable handling of cables can be achieved, wherein cables, in particular patch cables, in particular the plurality of cables, can be pulled out or pushed in the movable unit 16a while the movable unit 16a is in the service position.

The movable unit 16a is locked in the service position and an uncontrolled movement of the movable unit 16a is blocked. For transferring the movable unit 16a from the service position into the storage position, the operating element 53a can be pushed in the push direction 96a, in particular parallel to the move direction 28a. By pushing the operating element 53a, the movable unit 16a slides along at least the guiding rail 26a and can be transferred from the service position to the storage position. When the movable unit 16a is in the storage position, the movable unit 16a can be transferred in the service position by pulling the operating element 53a in the pull direction 94a. By pulling the operating element 53a the movable unit 18a slides along at least the guiding rail 26a and can be transferred from the storage position to the service position.

When the movable unit 16a is in the storage position and the operating element 53a is pushed in the push direction 96a, the blocking element 102a is compressed for blocking the movement of the movable unit 16a. The blocking element 102a comprises a blocking nose 104a. When the movable unit 16a is in the storage position and the operating element 53a is pushed in the push direction 96a, the blocking element 102a is deformed, preferably compressed, and the blocking nose 104a blocks the movement of the movable unit 18a in the push direction 96a. This can prevent the movable unit 18a from slipping out and/or falling out from the guiding rail 26a in the push direction 96a in an uncontrolled manner.

Figure 15 shows that the guiding rail 26a comprises at least one notch 112a. When the movable assembly 16a is at least partially arranged in the service and/or the storage position, the movable unit 18a is arranged between two guiding bars of the guiding unit 50a, advantageously between an upper bar 106a and a lower bar 108a. In this present case, the upper bar 106a comprises at least the notch 112a. Further, the movable unit 18a contacts the lower bar 108a, in particular can lay on the lower bar 108a, when the movable unit 16a is at least partially arranged in the receiving space 83a, namely in the service and/or the storage position. When the movable unit 16a is in the storage position and the operating element 53a is pushed in the push direction 96a, the blocking element 102a is deforming, preferably compressing, and the blocking nose 104a is contacting the notch 112a and sticks in the notch 112a for blocking the movement of the movable unit 16a in the push direction 96a.

The fixing unit 20a comprises a latch 76a, which is arrangeable in a recess 78a of the guiding rail 26a for fixing the movable unit 18a to the guiding rail 26a in the storage position. The guiding rail 26a comprises a further recess 110a. In this present case, the further recess 110a defines the service position. The latch 76a of the fixing unit 20a is arrangeable in the further recess 110a for arranging the movable unit 18a in the service position. Further, the guiding rail 26a comprises at least one relief element 114a. When the movable unit 18a is arranged in the service position, namely the latch 76a is arranged in the further recess 110a, the relief element 114a is intended for relieving stress on the blocking element 102a. Figure 15 shows that the guiding unit 50a is symmetrical with respect to a symmetry plane, which is perpendicular to the move direction 28a.

The fixing unit 20a comprises at least one flexible arm 80a connected to the latch 76a and to a body element 86a of the fixing unit 20a (cf. figures 13 and 14). Furthermore, the fixing unit 20a comprises at least one further flexible arm 82a connected to the latch 76a and to the body element 86a of the fixing unit 20a. The further flexible arm 82a is arranged relative to the flexible arm 80a on an opposite side of the latch 76a. Further, the fixing unit 20a comprises a resetting unit 70a for transferring the fixing unit 20a from the release position into a rest position. Figures 13 and 14 show a rest position of the resetting unit 70a. The resetting unit 70a comprises at least one spring element 72a, which cooperates with the movable unit 18a for transferring the fixing unit 20a from the release position into the rest position. In this embodiment according to figures 12 to 14, the spring element 72a is part of the flexible arm 80a. The spring element 72a and the flexible arm 80a are made in a one-piece embodiment. The resetting unit 70a comprises at least one further spring element 74a, which cooperates with the movable unit 18a for transferring the fixing unit 20a from a further release position into the rest position. The further spring element 74a is part of the further flexible arm 82a. The further spring element 74a and the further flexible arm 82a are made in a one-piece embodiment. Whereas figure 14 shows only the fixing unit 20a, figure 13 shows the fixing unit 20a arranged in the housing element 98a of the movable unit 18a, wherein the housing element 98a is sliced.

### Reference numerals

- 10: drawer system
- 12: base unit
- 16: movable assembly
- 18: movable unit
- 20: fixing unit
- 21: fixing unit
- 23: movable unit
- 26: guiding rail
- 28: move direction
- 30: extension
- 32: extension
- 34: depth direction
- 36: hight direction
- 38: width direction
- 50: guiding unit
- 52: guiding unit
- 53: operating element
- 56: operating element
- 60: rack
- 62: network cabinet
- 64: carrier unit
- 66: frame unit
- 68: guiding rail
- 70: resetting unit
- 72: spring element
- 74: spring element
- 76: latch
- 78: recess
- 80: flexible arm
- 82: flexible arm
- 83: receiving space
- 86: body element
- 88: thickness
- 90: stopping element
- 92: stopping element
- 94: pull direction
- 96: push direction
- 98: housing element
- 100: releasing step
- 102: blocking element
- 104: blocking nose
- 106: bar
- 108: bar
- 110: recess
- 112: notch
- 114: relief element

## Claims

1. A movable assembly (16, 16a), which is embodied as a drawer unit, comprising a movable unit (18, 18a) and further comprising at least one fixing unit (20,20a) for reversibly fixing the moveable unit (18, 18a) in at least one guiding rail (26, 26a), wherein the fixing unit (20, 20a) is moveable parallel to a move direction (28, 28a), namely an insertion direction, which is a direction in which the movable unit (18, 18a) and/or the fixing unit (20, 20a) is inserted into at least the guiding rail (26, 26a), of the moveable unit (18, 18a) into a release position in order to release the moveable unit (18, 18a) from the guiding rail (26, 26a), **characterized in that** the fixing unit (20a) comprises at least one operating element (53a), which can be pulled or pushed parallel to the move direction (28a) and which can only be pulled parallel to the move direction (28a) to release the moveable unit (18a) from the guiding rail (26a) in a pull direction (94a), wherein if the moveable unit (18a) is in a storage position and the operating element (53a) is pushed parallel to the move direction (28a), the operating element (53a) is intended to block a movement of the moveable unit (18a) in a push direction (96a).

2. The movable assembly (16, 16a) according to claim1, **characterized in that** the fixing unit (20, 20a) is made in a one-piece embodiment.

3. The movable assembly (16, 16a) according to claim 1 or 2, **characterized in that** the fixing unit (20, 20a) is bar-shaped.

4. The movable assembly (16, 16a) according to any one of the preceding claims,
**characterized in that** a total width extension of the fixing unit (20, 20a) is maximum 10 mm.

5. The movable assembly (16) according to any one of the preceding claims,
**characterized in that** the fixing unit (20) is symmetrical with respect to a symmetry plane, which is perpendicular to the move direction (28).

6. The movable assembly (16, 16a) according to any one of the preceding claims,
**characterized by** a resetting unit (70, 70a) for transferring the fixing unit (20, 20a) from the release position into a rest position.

7. The movable assembly (16, 16a) according to claim 6, **characterized in that** the resetting unit (70, 70a) comprises at least one spring element (72, 72a), which is implemented for transferring the fixing unit (20, 20a) from the release position into the rest position.

8. The movable assembly (16, 16a) according to any one of the preceding claims,
**characterized by** a latch (76, 76a), which is arrangeable in a recess (78, 78a) of the guiding rail (26, 26a) for fixing the moveable unit (18, 18a) to the guiding rail (26, 26a).

9. The movable assembly (16, 16a) according to claim 8, **characterized by** at least one flexible arm (80, 80a) connected to the latch (76, 76a) and to a body element (86, 86a) of the fixing unit (20, 20a).

10. The movable assembly (16, 16a) according to claim 9, **characterized in that** the flexible arm (80, 80a) is deformed when the fixing unit (20, 20a) is in the release position.

11. The moveable assembly (16, 16a) according to any of the preceding claims,
**characterized in that** an extension (30, 30a) of the fixing unit (20, 20a) is greater than an extension (32, 32a) of the moveable unit (18, 18a) when viewed in depth direction (34, 34a).

12. A base unit (12), in particular a cable management unit, comprising at least one moveable assembly (16, 16a) according to any of the preceding claims and the guiding rail (26, 26a).

13. A method for releasing a moveable assembly (16, 16a), according to any of the preceding claims 1 to 11, from a guiding rail (26, 26a) of a base unit (12), according to claim 12, wherein a fixing unit (20, 20a) is moved parallel to a move direction (28, 28a) of a moveable unit (18, 18a) into a release position in order to release the moveable unit (18, 18a) from a guiding rail (26, 26a) of the base unit (12), **characterized in that** at least one operating element (53a) is pulled parallel to the move direction (28a) to release the moveable unit (18a) from the guiding rail (26a) in a pull direction (94a), wherein if the moveable unit (18a) is in a storage position and the operating element (53a) is pushed parallel to the move direction (28a), the operating element (53a) blocks a movement of the moveable unit (18a) in a push direction (96a).

## Patentansprüche

1. Bewegliche Baugruppe (16, 16a), die als Schubladeneinheit ausgebildet ist und eine bewegliche Einheit (18, 18a) und ferner mindestens eine Fixiereinheit (20, 20a) zum reversiblen Fixieren der beweglichen Einheit (18, 18a) in mindestens einer Führungsschiene (26, 26a) umfasst, wobei die Fixiereinheit (20, 20a) parallel zu einer Bewegungsrichtung (28, 28a), nämlich einer Einschubrichtung, die eine Richtung ist, in der die bewegliche Einheit (18, 18a) und/oder die Fixiereinheit (20, 20a) in mindestens die Führungsschiene (26, 26a) der beweglichen Einheit (18, 18a) in eine Freigabeposition beweglich ist, um die bewegliche Einheit (18, 18a) von der Führungsschiene (26, 26a) freizugeben, **dadurch gekennzeichnet, dass** die Fixiereinheit (20a) mindestens ein Betätigungselement (53a) aufweist, das parallel zu der Bewegungsrichtung (28a) gezogen oder geschoben werden kann und das nur parallel zu der Bewegungsrichtung (28a) gezogen werden kann, um die bewegliche Einheit (18a) in einer Zugrichtung (94a) von der Führungsschiene (26a) freizugeben, wobei, wenn sich die bewegliche Einheit (18a) in einer Aufbewahrungsposition befindet und das Betätigungselement (53a) parallel zu der Bewegungsrichtung (28a) geschoben wird, das Betätigungselement (53a) dazu vorgesehen ist, eine Bewegung der beweglichen Einheit (18a) in einer Schieberichtung (96a) zu blockieren.

2. Bewegliche Baugruppe (16, 16a) nach Anspruch 1, **dadurch gekennzeichnet, dass** die Fixiereinheit (20, 20a) einstückig ausgebildet ist.

3. Bewegliche Baugruppe (16, 16a) nach Anspruch 1 oder 2, **dadurch gekennzeichnet, dass** die Fixiereinheit (20, 20a) stabförmig ist.

4. Bewegliche Baugruppe (16, 16a) nach einem der vorhergehenden Ansprüche, **dadurch gekennzeichnet, dass** eine Gesamtbreitenausdehnung der Fixiereinheit (20, 20a) maximal 10 mm beträgt.

5. Bewegliche Baugruppe (16) nach einem der vorhergehenden Ansprüche, **dadurch gekennzeichnet, dass** die Fixiereinheit (20) symmetrisch bezüglich einer Symmetrieebene ist, die senkrecht zu der Bewegungsrichtung (28) ist.

6. Bewegliche Baugruppe (16, 16a) nach einem der vorhergehenden Ansprüche, **gekennzeichnet durch** eine Rückstelleinheit (70, 70a) zum Überführen der Fixiereinheit (20, 20a) von der Freigabeposition in eine Ruheposition.

7. Bewegliche Baugruppe (16, 16a) nach Anspruch 6, **dadurch gekennzeichnet, dass** die Rückstelleinheit (70, 70a) mindestens ein Federelement (72, 72a) umfasst, das zum Überführen der Fixiereinheit (20, 20a) von der Freigabeposition in die Ruheposition ausgebildet ist.

8. Bewegliche Baugruppe (16, 16a) nach einem der vorhergehenden Ansprüche, **gekennzeichnet durch** einen Riegel (76, 76a), der in einer Ausnehmung (78, 78a) der Führungsschiene (26, 26a) anordenbar ist, zum Fixieren der beweglichen Einheit (18, 18a) an der Führungsschiene (26, 26a).

9. Bewegliche Baugruppe (16, 16a) nach Anspruch 8, **gekennzeichnet durch** mindestens einen flexiblen Arm (80, 80a), der mit dem Riegel (76, 76a) und mit einem Körperelement (86, 86a) der Fixiereinheit (20, 20a) verbunden ist.

10. Bewegliche Baugruppe (16, 16a) nach Anspruch 9, **dadurch gekennzeichnet, dass** der flexible Arm (80, 80a) verformt ist, wenn die Fixiereinheit (20, 20a) in der Freigabeposition ist.

11. Bewegliche Baugruppe (16, 16a) nach einem der vorhergehenden Ansprüche, **dadurch gekennzeichnet, dass** eine Ausdehnung (30, 30a) der Fixiereinheit (20, 20a) in Tiefenrichtung (34, 34a) gesehen größer ist als eine Ausdehnung (32, 32a) der beweglichen Einheit (18, 18a).

12. Basiseinheit (12), insbesondere Kabelführungseinheit, die mindestens eine bewegliche Baugruppe (16, 16a) nach einem der vorhergehenden Ansprüche und die Führungsschiene (26, 26a) umfasst.

13. Verfahren zum Freigeben einer beweglichen Baugruppe (16, 16a) nach einem der vorhergehenden Ansprüche 1 bis 11 von einer Führungsschiene (26, 26a) einer Basiseinheit (12) nach Anspruch 12, wobei eine Fixiereinheit (20, 20a) parallel zu einer Bewegungsrichtung (28, 28a) einer beweglichen Einheit (18, 18a) in eine Freigabeposition bewegt wird, um die bewegliche Einheit (18, 18a) von einer Führungsschiene (26, 26a) der Basiseinheit (12) freizugeben, **dadurch gekennzeichnet, dass** mindestens ein Betätigungselement (53a) parallel zu der Bewegungsrichtung (28a) gezogen wird, um die bewegliche Einheit (18a) in einer Zugrichtung (94a) von der Führungsschiene (26a) freizugeben, wobei, wenn sich die bewegliche Einheit (18a) in einer Aufbewahrungsposition befindet und das Betätigungselement (53a) parallel zu der Bewegungsrichtung (28a) geschoben wird, das Betätigungselement (53a) eine Bewegung der beweglichen Einheit (18a) in einer Schieberichtung (96a) blockiert.

## Revendications

1. Ensemble mobile (16, 16a), qui est réalisé sous forme d'unité de tiroir, comprenant une unité mobile (18, 18a) et comprenant en outre au moins une unité de fixation (20, 20a) pour fixer de manière réversible l'unité mobile (18, 18a) dans au moins un rail de guidage (26, 26a), où l'unité de fixation (20, 20a), parallèlement à une direction de déplacement (28, 28a), à savoir une direction d'insertion, qui est une direction dans laquelle l'unité mobile (18, 18a) et/ou l'unité de fixation (20, 20a) est mobile dans au moins le rail de guidage (26, 26a) de l'unité mobile (18, 18a) dans une position de libération pour libérer l'unité mobile (18, 18a) du rail de guidage (26, 26a), **caractérisé en ce que** l'unité de fixation (20a) comprend au moins un élément d'actionnement (53a), qui peut être tiré ou poussé parallèlement à la direction de déplacement (28a) et qui ne peut être tiré parallèlement à la direction de déplacement (28a) que pour libérer l'unité mobile (18a) du rail de guidage (26a) dans une direction de traction (94a), où, lorsque l'unité mobile (18a) est dans une position de stockage et que l'élément d'actionnement (53a) est poussé parallèlement à la direction de déplacement (28a), l'élément d'actionnement (53a) est prévu pour bloquer un déplacement de l'unité mobile (18a) dans une direction de poussée (96a).

2. Ensemble mobile (16, 16a) selon la revendication 1, **caractérisé en ce que** l'unité de fixation (20, 20a) est réalisée sous forme d'une seule pièce.

3. Ensemble mobile (16, 16a) selon la revendication 1 ou 2, **caractérisé en ce que** l'unité de fixation (20, 20a) est en forme de barre.

4. Ensemble mobile (16, 16a) selon l'une quelconque des revendications précédentes, **caractérisé en ce qu'**une extension de largeur totale de l'unité de fixation (20, 20a) est au maximum de 10 mm.

5. Ensemble mobile (16) selon l'une quelconque des revendications précédentes, **caractérisé en ce que** l'unité de fixation (20) est symétrique par rapport à un plan de symétrie, qui est perpendiculaire à la direction de déplacement (28).

6. Ensemble mobile (16, 16a) selon l'une quelconque des revendications précédentes, **caractérisé par** une unité de rappel (70, 70a) pour transférer l'unité de fixation (20, 20a) de la position de libération dans une position de repos.

7. Ensemble mobile (16, 16a) selon la revendication 6, **caractérisé en ce que** l'unité de rappel (70, 70a) comprend au moins un élément de ressort (72, 72a), qui est réalisé pour transférer l'unité de fixation (20, 20a) de la position de libération dans la position de repos.

8. Ensemble mobile (16, 16a) selon l'une quelconque des revendications précédentes, **caractérisé par** un verrou (76, 76a), qui peut être disposé dans un évidement (78, 78a) du rail de guidage (26, 26a) pour fixer l'unité mobile (18, 18a) au rail de guidage (26, 26a).

9. Ensemble mobile (16, 16a) selon la revendication 8, **caractérisé par** au moins un bras flexible (80, 80a) relié au verrou (76, 76a) et à un élément de corps (86, 86a) de l'unité de fixation (20, 20a).

10. Ensemble mobile (16, 16a) selon la revendication 9, **caractérisé en ce que** le bras flexible (80, 80a) est déformé lorsque l'unité de fixation (20, 20a) est dans la position de libération.

11. Ensemble mobile (16, 16a) selon l'une quelconque des revendications précédentes, **caractérisé en ce qu'**une extension (30, 30a) de l'unité de fixation (20, 20a) est plus grande qu'une extension (32, 32a) de l'unité mobile (18, 18a) lorsqu'elle est vue dans la direction de profondeur (34, 34a).

12. Unité de base (12), en particulier unité de gestion de câble, comprenant au moins un ensemble mobile (16, 16a) selon l'une quelconque des revendications précédentes et le rail de guidage (26, 26a).

13. Procédé pour libérer un ensemble mobile (16, 16a), selon l'une quelconque des revendications précédentes 1 à 11, d'un rail de guidage (26, 26a) d'une unité de base (12) selon la revendication 12, où une unité de fixation (20, 20a) est déplacée parallèlement à une direction de déplacement (28, 28a) d'une unité mobile (18, 18a) dans une position de libération pour libérer l'unité mobile (18, 18a) d'un rail de guidage (26, 26a) de l'unité de base (12), **caractérisé en ce qu'**au moins un élément d'actionnement (53a) est tiré parallèlement à la direction de déplacement (28a) pour libérer l'unité mobile (18a) du rail de guidage (26a) dans une direction de traction (94a), où, lorsque l'unité mobile (18a) est dans une position de stockage et que l'élément d'actionnement (53a) est poussé parallèlement à la direction de déplacement (28a), l'élément d'actionnement (53a) bloque un déplacement de l'unité mobile (18a) dans une direction de poussée (96a).
